# FASCICULE DE BREVET EUROPEEN

(11) **EP 3 732 150 B1**
(45) Date de publication et mention de la délivrance du brevet: **25.01.2023**
(21) Numéro de dépôt: 18833977.4
(22) Date de dépôt: 18.12.2018
(51) Int. Cl.: C04B 35/628, C23C 16/44, C23C 16/02, C23C 16/511, C23C 18/14, C23C 18/12, C04B 41/45

(54) **PROCÉDÉ DE DÉPÔT D'UN REVÊTEMENT SUR DES FIBRES COURTES PAR CALÉFACTION**
VERFAHREN ZUM AUFBRINGEN EINER BESCHICHTUNG AUF KURZFASERN DURCH ERWÄRMUNG
PROCESS FOR DEPOSITING A COATING ON SHORT FIBRES BY CALEFACTION

(30) Priorité: 26.12.2017 FR 1763216
(43) Date de publication de la demande: 04.11.2020
(73) Titulaire: Safran Ceramics, 33185 Le Haillan (FR); Centre National de la Recherche Scientifique, 75016 Paris (FR); UNIVERSITE DE BORDEAUX, 33000 Bordeaux (FR)
(72) Inventeur: DELEHOUZE, Arnaud, 77550 MOISSY-CRAMAYEL (FR); PETIBON, Fanny, 74560 LA MURAZ (FR)
(74) Mandataire: Cabinet Beau de Loménie
(86) Numéro de dépôt international: PCT/FR2018/053382
(87) Numéro de publication internationale: WO 2019/129950

(56) Documents cités:
- EP-A2- 0 515 186
- EP-A2- 0 592 239
- WO-A1-95/14645
- US-A- 6 143 376
- Anonymous: "Cavité résonnante", , 2 novembre 2017 (2017-11-02), XP055509208, Extrait de l'Internet: URL:https://fr.wikipedia.org/wiki/Cavité_r ésonnante [extrait le 2018-09-24]
- Anonymous: "RESULTATS CONCOURS DOCTORANTS SAMPE EUROPE 2017 MATERIALS & PROCESSES", , 16 novembre 2017 (2017-11-16), XP055508935, Extrait de l'Internet: URL:http://www.sampe-france.org/?q=en/cont ent/resultats-concours-doctorants-sampe-eu rope-2017-materials-processes [extrait le 2018-09-21]
- Christian Klein: "Etude du procédé de densification par caléfaction de composites C/C, modélisation, optimatisation du contrôle et du bilan énergétique", , 15 décembre 2015 (2015-12-15), XP055508985, Extrait de l'Internet: URL:https://www.theses.fr/2015BORD0231 [extrait le 2018-09-24]

## Description

### Arrière-plan de l'invention

La présente invention se rapporte au domaine général des procédés de dépôt d'un revêtement sur des fibres, et plus particulièrement sur des fibres courtes en carbone ou en carbure de silicium par caléfaction à partir d'un précurseur du revêtement.

Les matériaux composites à matrice céramique (CMC), connus pour leurs bonnes propriétés mécaniques qui les rendent aptes à constituer des éléments de structures et pour conserver ces propriétés à températures élevées, constituent une alternative viable aux traditionnelles pièces métalliques. Leur masse réduite par rapport à leur équivalent métallique en font des pièces de choix pour répondre aux problématiques d'augmentation du rendement et de réduction des émissions polluantes des moteurs dans le domaine aéronautique.

Les pièces en matériau CMC comprennent un renfort fibreux généralement continu sous la forme d'un textile tissé, qui est densifié par une matrice céramique. Le renfort fibreux comprend ainsi des fibres longues continues, dont l'orientation peut être adaptée aux directions principales de sollicitation de la pièce lors de son utilisation. La préforme destinée à former le renfort fibreux doit être tissée à partir des fibres continues aux dimensions de la pièce (par exemple par tissage bidimensionnel ou tridimensionnel), à l'aide d'un métier à tisser adapté. L'étape de tissage est un processus long et coûteux qui n'est pas adapté pour réaliser des pièces de petite taille.

Une solution pour réaliser des pièces de petite taille est de les obtenir par un procédé mettant en oeuvre un mélange de fibres courtes et d'un liant éliminable qui est mis en forme en ébauche, le liant est ensuite éliminé de l'ébauche, et enfin consolidé par un traitement thermique. L'introduction de procédés de ce type pose toutefois le problème du dépôt de l'interphase sur ces fibres.

On connaît des techniques de dépôt d'une interphase sur des fibres continues ou des textiles tissés à partir de telles fibres, qui comprennent l'infiltration ou le dépôt en phase gazeuse (CVI/CVD) de ces fibres à partir d'un précurseur à l'état gazeux de l'interphase. Le problème de ces techniques est que les fibres doivent ensuite être découpées pour former des fibres courtes, ce qui peut endommager l'interphase et résulter en de mauvaise propriétés mécaniques du matériau CMC obtenu après densification. On connaît US 6143376 qui divulgue un procédé de fabrication de fibres courtes revêtues.

Il existe donc un besoin pour un procédé de dépôt d'un revêtement sur des fibres courtes qui permette de déposer directement sur des fibres courtes un revêtement d'interphase homogène et continu sur toute la surface des fibres.

### Objet et résumé de l'invention

La présente invention a donc pour but principal de pallier de tels inconvénients en proposant un procédé selon la revendication 1.

Le procédé selon l'invention est remarquable notamment par le fait que les fibres courtes sont chauffées par l'intermédiaire de micro-ondes et que le dépôt est réalisé directement sur ces dernières par caléfaction. Les inventeurs ont en effet observé que les fibres courtes en carbone ou en carbure de silicium couplent directement avec un champ micro-onde, ce qui permet de porter leur surface à une température suffisante pour réaliser la formation du revêtement par caléfaction à partir d'un précurseur en phase liquide de ce revêtement. En particulier, la surface des fibres peut être portée à une température très supérieure à la température de craquage du précurseur de revêtement. Chaque fibre courte devient en quelque sorte un réacteur de caléfaction autonome. Contrairement à certaines techniques de l'art antérieur, chaque fibre courte est recouverte entièrement par le revêtement, c'est-à-dire sa surface latérale généralement cylindrique et ses extrémités lorsqu'une fibre courte est identifiée à un cylindre. Ce procédé permet ainsi de déposer directement le revêtement sur les fibres courtes de façon simple et homogène. Un autre avantage du procédé selon l'invention est que le précurseur de revêtement en phase liquide couple avec le champ micro-ondes, ce qui augmente sa température, réduit la dissipation thermique autour des fibres courtes et améliore la cinétique de la caléfaction. Le couplage de la phase liquide du précurseur avec le champ micro-ondes le porte également à ébullition, ce qui a pour effet d'améliorer l'homogénéisation du mélange, et ainsi le dépôt de revêtement. Encore un autre avantage de l'invention est la réduction de l'énergie nécessaire pour former le revêtement, car on chauffe directement les fibres.

Une fibre peut comprendre une pluralité de filaments, dans ce cas, on entend alors par « surface d'une fibre », la surface de chaque filament qui compose la fibre. De manière similaire, on entend par « déposer » ou « former » un revêtement sur une fibre, le dépôt ou la formation du revêtement sur la surface de chaque filament qui compose la fibre, le cas échéant.

On entend par « champ micro-ondes » un champ électromagnétique de fréquence de plusieurs centaines de MHz à plusieurs GHz. Le champ micro-ondes peut être caractérisé par sa puissance (ou amplitude) et sa fréquence, que l'homme du métier pourra déterminer aisément pour obtenir une température de surface des fibres courtes suffisante pour former le revêtement par caléfaction. Il existe en effet une multiplicité de couples fréquence/puissance qui permet d'obtenir un couplage suffisant entre les fibres courtes et le champ micro-ondes.

On notera que des fibres longues présentent généralement une longueur supérieure à 5 mm.

Dans un exemple de réalisation, le champ micro-ondes présente une fréquence principale comprise entre 2,35 GHz et 2,55 GHz.

Dans un exemple de réalisation, la longueur des fibres courtes peut être comprise entre 100 µm et 300 µm.

Selon l'invention, le revêtement est un revêtement d'interphase. L'interphase a une fonction de défragilisation du matériau composite qui favorise la déviation de fissures éventuelles parvenant à l'interphase après s'être propagées dans la matrice, empêchant ou retardant la rupture de fibres par de telles fissures. Cette interphase permet également de protéger les fibres courtes du matériau de la matrice lors de sa formation.

Le revêtement comprend du carbone pyrolytique (PyC), du nitrure de bore (BN), du carbure de silicium (SiC), du Si₃N₄ ou du SiBN.

Dans un exemple de réalisation, les fibres courtes peuvent être en carbure de silicium présentant une teneur en oxygène inférieure ou égale à 1% en pourcentage atomique. Par exemple une telle fibre peut être une fibre du type Hi-Nicalon type S commercialisées par la société japonaise NGS.

Dans un exemple de réalisation, le champ micro-ondes peut être obtenu à l'aide d'un résonateur présentant une cavité résonante. Dans ce cas le seul paramètre à régler pour moduler la température de surface des fibres est la puissance fournie au résonateur, car ce dernier possède généralement une fréquence de résonnance fixe. On peut veiller à ce que les fibres courtes et le précurseur en phase liquide soient placés au sein d'un ventre du champ micro-ondes, ce qui est le cas lorsque l'on utilise un tel résonateur et que l'on place les fibres et le précurseur au centre de sa cavité résonante. Bien entendu, d'autres moyens pour générer des micro-ondes peuvent être utilisés.

### Brève description des dessins

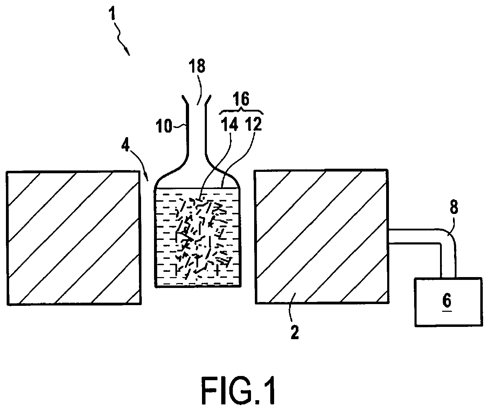

D'autres caractéristiques et avantages de la présente invention ressortiront de la description faite ci-dessous, en référence au dessin annexé qui en illustre un exemple de réalisation dépourvu de tout caractère limitatif. La figure 1 montre un exemple de dispositif permettant de mettre en oeuvre un procédé selon l'invention.

### Description détaillée de l'invention

La figure 1 montre un dispositif permettant de mettre en oeuvre un procédé selon l'invention.

Le dispositif 1 comprend un résonateur 2 muni d'une cavité résonante 4, le résonateur est connecté à un générateur d'ondes 6 par un câble coaxial 8. En fonctionnement, la cavité résonante 4 est parcourue par un champ micro-ondes. Un réacteur 10 en un matériau préférentiellement transparent aux micro-ondes (par exemple en quartz) est placé au sein de la cavité résonante 4. Le réacteur 10 prend ici la forme d'un flacon. Le réacteur 10 contient une phase liquide 12 d'un précurseur de revêtement dans lequel sont présentes des fibres courtes 14 en carbone ou en carbure de silicium, formant ensemble un mélange 16. Les fibres courtes 14 sont dispersées dans la phase liquide 12, c'est-à-dire qu'elles ne sont pas liées entre elles et ne forment pas une préforme de pièce à ce stade. Le réacteur 10 peut être pourvu au niveau de son ouverture 18 de moyens pour alimenter le réacteur en phase liquide 12 du précurseur, par exemple une ampoule d'addition, et de moyens pour empêcher l'échappement du précurseur vaporisé, par exemple un montage à reflux (non représentés). Le dispositif 1 peut en outre comprendre des moyens usuels d'homogénéisation du mélange 16, par exemple un agitateur magnétique ou une hélice en quartz (non représentés).

Pour déposer un revêtement sur les fibres courtes par un procédé selon l'invention, on active le générateur 6 ce qui a pour effet de créer un champ micro-ondes dans la cavité résonante 4 dans laquelle est présent le réacteur 10. Les fibres courtes 14 couplent avec le champ micro-ondes ce qui a pour effet de les chauffer en augmentant notamment leur température de surface. Lorsque la puissance du champ micro-ondes est suffisante, la phase liquide du précurseur de revêtement 12 se vaporise à proximité des fibres courtes 14 et le précurseur ainsi vaporisé peut former le revêtement directement sur les fibres courtes par caléfaction.

Comme indiqué précédemment, l'homme du métier sait déterminer la puissance (et/ou la fréquence si celle-ci est variable) du champ micro-ondes pour obtenir un couplage suffisant et la température adéquate permettant le dépôt par caléfaction. De même, l'épaisseur du revêtement déposé est, toutes choses étant égales par ailleurs, fonction du temps de séjour des fibres courtes et du précurseur en phase liquide dans le champ micro-ondes. L'homme du métier peut ainsi déterminer le temps de séjour nécessaire pour obtenir une certaine épaisseur moyenne de revêtement.

Les fibres courtes 14 peuvent être en carbone ou en carbure de silicium (SiC). Par exemple de telles fibres courtes peuvent être des fibres du type Hi-Nicalon type S commercialisées par la société japonaise NGS. Les fibres courtes en carbure de silicium sont préférées. Les fibres courtes peuvent avoir été obtenues à partir de fibres longues continues qui sont découpées ou broyées.

On peut former à l'aide d'un procédé selon l'invention une interphase sur les fibres courtes. On peut former par exemple une interphase en carbone pyrolytique (PyC) à l'aide d'un précurseur de revêtement tel qu'un alcool, par exemple l'éthanol, un polyalcool ou du toluène. On peut former par exemple une interphase en carbure de silicium à l'aide d'un précurseur de revêtement tel que le méthyltrichlorosilane ou le diméthylchlorosilane. On peut former par exemple une interphase en nitrure de bore (BN) à l'aide d'un précurseur de revêtement tel que la borazine, ou un mélange de BCl₃ et de NH₃.

Les fibres courtes ainsi revêtues d'une interphase pourront ensuite être utilisées par exemple pour fabriquer une pièce en matériau composite à matrice céramique.

### Exemple

On dépose une interphase de pyrocarbone sur des fibres courtes en carbure de silicium par un exemple de procédé selon l'invention. Pour ce faire on prépare un mélange comprenant des fibres courtes en carbure de silicium Hi-Nicalon type S présentant une longueur moyenne de l'ordre de 200 µm et 10 µm de diamètre (diamètre moyen des filaments), et de l'éthanol. Le mélange est placé dans un réacteur adapté au sein de la cavité résonante d'un résonateur présentant une fréquence propre de l'ordre de 2,45 GHz et alimenté par une puissance 300 W. Le mélange est ainsi soumis au champ micro-ondes pendant une durée d'environ 10 minutes. On a obtenu des fibres courtes revêtues d'une interphase de pyrocarbone homogène et continue sur la surface des fibres.

## Revendications

1. Procédé de dépôt d'un revêtement sur des fibres courtes (14) en carbone ou en carbure de silicium à partir d'un précurseur de revêtement (12), les fibres courtes (14) présentant une longueur comprise entre 50 µm et 5 mm, le procédé étant **caractérisé en ce qu'**il comprend au moins :
le chauffage des fibres courtes par placement d'un mélange (16) comprenant lesdites fibres et une phase liquide du précurseur de revêtement dans un champ micro-ondes de façon à porter la surface des fibres à une température permettant la formation par caléfaction du revêtement sur les fibres à partir du précurseur de revêtement, le revêtement étant un revêtement d'interphase comprenant du carbone pyrolytique, du nitrure de bore, du carbure de silicium, du nitrure de silicium Si₃N₄, ou du SiBN, et la phase liquide du précurseur couplant avec le champ micro-ondes afin de le porter à ébullition.

2. Procédé selon la revendication 1, dans lequel la longueur des fibres courtes (14) est comprise entre 100 µm et 300 µm.

3. Procédé selon la revendication 1 ou 2, dans lequel les fibres courtes sont en carbure de silicium présentant une teneur en oxygène inférieure ou égale à 1% en pourcentage atomique.

4. Procédé selon l'une quelconque des revendications 1 à 3, dans lequel le champ micro-ondes est obtenu à partir d'un résonateur (2) présentant une cavité résonante (4).

5. Procédé selon l'une quelconque des revendications 1 à 4, dans lequel les fibres courtes sont obtenues à partir de fibres longues continues qui sont découpées ou broyées.

6. Procédé de fabrication d'une pièce en matériau composite à matrice céramique comprenant une étape de formation d'une matrice céramique autour de fibres courtes sur lesquelles un revêtement a été déposé par un procédé selon l'une quelconque des revendications 1 à 5.

## Patentansprüche

1. Verfahren zum Aufbringen einer Beschichtung auf Kurzfasern (14) aus Carbon oder aus Siliciumcarbid ausgehend von einem Beschichtungsvorläufer (12), wobei die Kurzfasern (14) eine Länge aufweisen, die zwischen 50 µm und 5 mm liegt, wobei das Verfahren **dadurch gekennzeichnet ist, dass** es mindestens Folgendes umfasst:
das Erwärmen der Kurzfasern durch Platzieren einer Mischung (16), die die Fasern und eine flüssige Phase des Beschichtungsvorläufers umfasst, in einem Mikrowellenfeld derart, dass die Oberfläche der Fasern auf eine Temperatur gebracht wird, die die Ausbildung der Beschichtung auf den Fasern ausgehend von dem Beschichtungsvorläufer durch Filmverdampfung erlaubt, wobei die Beschichtung eine Zwischenphasenbeschichtung ist, die pyrolytischen Kohlenstoff, Bornitrid, Siliciumcarbid, Siliciumnitrid Si₃N₄ oder SiBN umfasst, und die flüssige Phase des Vorläufers mit dem Mikrowellenfeld koppelt, um ihn zum Sieden zu bringen.

2. Verfahren nach Anspruch 1, wobei die Länge der Kurzfasern (14) zwischen 100 µm und 300 µm liegt.

3. Verfahren nach Anspruch 1 oder 2, wobei die Kurzfasern aus Siliciumcarbid sind, das einen Sauerstoffgehalt von unter oder gleich 1% in Atomprozent aufweist.

4. Verfahren nach einem der Ansprüche 1 bis 3, wobei das Mikrowellenfeld ausgehend von einem Resonator (2) erhalten wird, der einen Resonanzhohlraum (4) aufweist.

5. Verfahren nach einem der Ansprüche 1 bis 4, wobei die Kurzfasern aus kontinuierlichen Langfasern erhalten werden, die geschnitten oder zerkleinert werden.

6. Verfahren zur Herstellung eines Teils aus Verbundmaterial mit keramischer Matrix, das einen Schritt des Bildens einer keramischen Matrix um Kurzfasern umfasst, auf denen eine Beschichtung mittels eines Verfahrens nach einem der Ansprüche 1 bis 5 aufgebracht wurde.

## Claims

1. Method for depositing a coating on short carbon or silicon carbide fibres (14) from a coating precursor (12), the short fibres (14) having a length of between 50 µm and 5 mm, the method being **characterised in that** it comprises at least:
heating the short fibres by placing a mixture (16) comprising said fibres and a liquid phase of the coating precursor in a microwave field so as to bring the surface of the fibres to a temperature which allows the formation, by film boiling, of the coating on the fibres from the coating precursor, the coating being an interphase coating comprising pyrolytic carbon, boron nitride, silicon carbide, silicon nitride Si₃N₄, or SiBN, and the liquid phase of the precursor coupling with the microwave field in order to bring it to the boil.

2. Method according to claim 1, wherein the length of the short fibres (14) is between 100 µm and 300 µm.

3. Method according to claim 1 or 2, wherein the short fibres are made of silicon carbide having an oxygen content less than or equal to 1% in atomic percent.

4. Method according to any one of claims 1 to 3, wherein the microwave field is obtained from a resonator (2) having a resonant cavity (4).

5. Method according to any one of claims 1 to 4, wherein the short fibres are obtained from continuous long fibres which are cut or ground.

6. Method for manufacturing a part made of a ceramic matrix composite material comprising a step of forming a ceramic matrix around short fibres on which a coating has been deposited by a method according to any one of claims 1 to 5.
